# FASCICULE DE BREVET EUROPEEN

(11) **EP 3 931 396 B1**
(45) Date de publication et mention de la délivrance du brevet: **30.11.2022**
(21) Numéro de dépôt: 20713946.0
(22) Date de dépôt: 25.02.2020
(51) Int. Cl.: H01L 31/0236, H01L 31/048, E01C 7/35, E01C 11/00

(54) **DISPOSITIF FONCTIONNEL INTEGRABLE DANS UNE CHAUSSEE CIRCULABLE ET PROCÉDÉ DE FABRICATION D'UN CHAUSSÉE CIRCULABLE AVEC UN TEL DISPOSITIF FONCTIONNEL**
IN EINE PASSIERBARE OBERFLÄCHE INTEGRIERTE FUNKTIONALE VORRICHTUNG UND VERFAHREN ZUR HERSTELLUNG EINER PASSIERBAREN OBERFLÄCHE DAMIT
FUNCTIONAL DEVICE INTEGRATED INTO A TRAVERSABLE SURFACE AND METHOD FOR PRODUCING A TRAVERSABLE SURFACE WITH SAME

(30) Priorité: 26.02.2019 FR 1901965
(43) Date de publication de la demande: 05.01.2022
(73) Titulaire: Commissariat à l'énergie atomique et aux énergies alternatives, 75015 Paris (FR); COLAS, 75015 Paris (FR)
(72) Inventeur: HESLINGA, Dick, 38054 GRENOBLE CEDEX 09 (FR); BOULANGER, Amandine, 38054 GRENOBLE CEDEX 09 (FR); COQUELLE, Eric, 78000 VERSAILLES (FR); DE BETTIGNIES, Rémi, 38054 GRENOBLE CEDEX 09 (FR); GAUME, Julien, 38054 GRENOBLE CEDEX 09 (FR); VITE, Marion, 38054 GRENOBLE CEDEX 09 (FR)
(74) Mandataire: Jacobacci Coralis Harle
(86) Numéro de dépôt international: PCT/FR2020/050359
(87) Numéro de publication internationale: WO 2020/174177

(56) Documents cités:
- WO-A1-2016/016170
- CN-A- 105 322 039

## Description

### DOMAINE TECHNIQUE

L'invention se rapporte à un dispositif fonctionnel, comprenant différentes couches entourant des éléments actifs, par exemple des cellules photovoltaïques, intégrable dans une chaussée circulable. Les couches du dispositif fonctionnel possèdent des caractéristiques thermomécaniques (module d'Young et coefficient de dilatation thermique) qui ont, par rapport à la couche centrale de la structure, (i) une symétrie ou une quasi-symétrie, et (ii) des gradients en U (décroissant/croissant) ou en U inversé (croissant/décroissant), de manière à conférer au dispositif une grande stabilité thermomécanique.

L'invention trouve une application privilégiée dans le domaine des routes solaires. Le dispositif est intégrable dans des chaussées circulables, pour des piétons et/ou des véhicules, motorisés ou non, telles que des chaussées ou routes, des pistes cyclables, des plateformes industrielles ou aéroportuaires, des places, des trottoirs, ou des parkings, par exemple.

L'invention se rapporte également à une chaussée circulable fonctionnalisée par des éléments actifs et à son procédé de fabrication.

### ÉTAT DE LA TECHNIQUE ANTÉRIEURE

Les chaussées fonctionnalisées sont des chaussées comprenant des éléments actifs tels que des cellules photovoltaïques ou encore des éléments électriques, électroniques, piézo-électriques, thermoélectriques et/ou de communication sans fil. Ces éléments peuvent permettre de capter des données et/ou de les communiquer, ou encore de générer et de transférer de l'énergie. En particulier, le principe des routes solaires consiste à utiliser les routes ou chaussées comme moyens de production d'énergie, à partir de l'irradiation solaire pendant la journée, que ce soit pour alimenter des bâtiments situés à proximité (entreprises, éco-quartiers, fermes solaires, maisons individuelles, entre autres), pour alimenter le réseau électrique et/ou des dispositifs d'aide à la circulation, par exemple. L'énergie photovoltaïque produite peut également être stockée, et servir, par exemple, pour la signalisation routière et/ou pour illuminer des aires de stationnement la nuit. Elle peut également être convertie en chaleur pour dégivrer les routes, les trottoirs, les parkings, les aéroports, etc.

Pour cela, des modules solaires sont insérés dans des chaussées dites circulables (routes, trottoirs, etc.), et recouverts par une surface texturée transparente, résistante au passage des véhicules, et répondant aux exigences d'adhérence applicables aux routes et autres voies circulées.

Classiquement, les modules photovoltaïques comprennent :
- une plaque transparente en face avant du module, généralement en verre ; la face avant étant celle exposée au rayonnement solaire incident après l'implantation des modules sur le terrain,
- un ensemble de cellules photovoltaïques interconnectées, noyées dans une (multi)couche d'encapsulation,
- une plaque de verre ou un 'backsheet' multi-couches en face arrière.

Cependant, pour une application du type route solaire, les modules photovoltaïques classiques avec une face avant en verre ne sont pas suffisamment flexibles pour se conformer à la déformation d'une route, celle-ci étant de l'ordre de 5 mm sur une distance type de 1 m pour les deux axes horizontaux, selon la largeur et la longueur, de la route. De plus, ces modules photovoltaïques classiques, posés ou collés sur une chaussée, ne sont pas suffisamment résistants aux charges mécaniques qu'ils peuvent subir sous le passage du trafic.. Par exemple, la rugosité de la chaussée peut provoquer un poinçonnement par la face arrière du module photovoltaïque. De façon similaire, un choc ou poinçonnement, e.g. par présence ou chute d'objets, peut survenir par la face avant du module. Ces mécanismes entraînent le risque de cassure du module ou des cellules photovoltaïques.

Des solutions ont été envisagées pour améliorer la résistance aux chocs et aux charges mécaniques et/ou la flexibilité du module photovoltaïque.

Par exemple, dans la demande internationale WO 2018/082609, un panneau photovoltaïque classique, ayant une épaisse plaque de verre en face avant, est recouvert par une couche de roulement, comprenant un matériau époxy et des additifs particulaires, pour assurer une bonne accroche anti-dérapage. Le panneau comprend en face arrière une couche isolante, par exemple en EVA, résine époxyde ou en un matériau composite polymère/fibres de verre pour assurer une protection contre la remontée de l'humidité.

Les documents US 8,907,202 et US 2018/0102730 décrivent des dispositifs fonctionnels intégrant des cellules photovoltaïques, et d'autres éléments actifs électroniques et optiques, tels que des diodes électroluminescentes. La protection mécanique des éléments actifs est assurée par une plaque en verre face avant et une plaque en verre en face arrière. Afin de minimiser les dommages en face avant dus aux contraintes mécaniques liées aux chocs et/ou aux contraintes de fréquences de vibrations, la plaque avant peut être du verre renforcé, recouverte de diamant ou encore présenter une structure de verre laminé.

Dans les documents WO2016/016170 et WO2016/016165, la face avant d'un module photovoltaïque, comprenant des cellules photovoltaïques en silicium cristallin, un laminé de polymères et de matériaux composites, est une matrice discrétisée de plaques de polymère résistant aux chocs, alignées avec les cellules photovoltaïques. Le module ainsi obtenu est flexible et peut être intégré sur une surface non plane. Cependant, cette technologie nécessite de choisir spécifiquement les matériaux polymères et/ou les matériaux composites employés, pour pouvoir répondre aux sollicitations mécaniques subies par les modules dans les conditions environnementales et de circulation réelles sur route. De plus, les plaques en face avant doivent être positionnées en regard des cellules photovoltaïques, ce qui complique le procédé de fabrication d'un tel dispositif.

Cependant, ces solutions sont focalisées sur la résistance mécanique des dispositifs par rapport à des chocs et/ou des charges. Elles ne prennent pas, ou presque pas, en compte les conditions climatiques auxquelles sont soumis ces dispositifs.

Un autre dispositif fonctionnel est aussi décrit dans le document CN105322039A.

### EXPOSÉ DE L'INVENTION

Le but de la présente invention est de proposer un dispositif fonctionnel, pouvant être intégré dans une chaussée circulable, présentant une intégrité structurelle et une intégrité fonctionnelle durables dans le temps, et ce pour toutes les conditions climatiques/météorologiques et pour toutes les conditions de circulation possibles.

Pour cela, la présente invention propose un dispositif fonctionnel, notamment intégrable dans une chaussée circulable, comprenant successivement :
- un premier film de protection également appelé première plaque de protection disposé en face avant du dispositif, en un premier matériau,
- un premier film encapsulant extérieur, en un deuxième matériau,
- un film encapsulant intérieur, en un troisième matériau,
- un deuxième film encapsulant extérieur, en un quatrième matériau,
- un deuxième film de protection également appelé deuxième plaque de protection, disposé en face arrière du dispositif, en un cinquième matériau,
- l'un des films choisis parmi le premier film encapsulant extérieur, le film encapsulant intérieur et le deuxième film encapsulant extérieur enrobant des éléments actifs,

le premier matériau, le deuxième matériau, le troisième matériau, le quatrième matériau et le cinquième matériau ayant, respectivement, des modules d'Young E₁, E₂, E₃, E₄ et E₅ et ayant, respectivement, des coefficients de dilatation thermique CTE₁, CTE₂, CTE₃, CTE₄, et CTE₅,
E₁ et E₅ étant semblables ou identiques, E₂ et E₄ étant semblables ou identiques,
E₁ > E₂ et E₄ < E₅ et avantageusement E₂ > E₃ et E₃ < E₄,
CTE₁ et CTE₅ étant semblables ou identiques, CTE₂ et CTE₄ étant semblables ou identiques,
CTE₁ < CTE₂ et CTE₄ > CTE₅ et avantageusement CTE₂< CTE₃ et CTE₃> CTE₄.

Par semblable, on entend que les valeurs ne diffèrent pas de plus de 30%, et de préférence, elles ne diffèrent pas de plus de 20% et avantageusement pas de plus de 10%. Avantageusement, les valeurs sont identiques.

Ici, et par la suite, sauf indication contraire, on entend par inférieur, strictement inférieur, et on entend par supérieur, strictement supérieur.

Ici, et par la suite, toutes les valeurs de modules d'Young et les valeurs des coefficients de dilatation thermique sont données à température ambiante (20-25°C).

L'invention se distingue fondamentalement de l'art antérieur, notamment, par l'architecture et la nature des différentes couches du dispositif fonctionnel, précédemment décrites. Les couches du dispositif forment un empilement qui présente :
- un gradient de module d'Young en U : décroissant depuis le premier film de protection en face avant jusqu'à la couche d'encapsulant extérieur et avantageusement jusqu'à la couche d'encapsulant intérieur, puis croissant depuis la couche d'encapsulant extérieur et avantageusement depuis la couche d'encapsulant intérieur jusqu'au deuxième film de protection en face arrière,
- un gradient de coefficient de dilatation thermique en U inversé : croissant depuis le premier film de protection en face avant jusqu'à la couche d'encapsulant extérieur et avantageusement jusqu'à la couche d'encapsulant intérieur, puis décroissant depuis la couche d'encapsulant extérieur et avantageusement depuis la couche d'encapsulant intérieur jusqu'au deuxième film de protection en face arrière,
- des propriétés thermomécaniques (module d'Young E et coefficient de dilatation thermique CTE) symétriques ou quasi-symétriques par rapport à la couche centrale de l'empilement de couches (i.e. le film d'encapsulant intérieur) : d'une part, le couple premier film de protection/deuxième film de protection présente des valeurs E et CTE semblables et, d'autre part, le couple premier film encapsulant extérieur/deuxième film encapsulant extérieur présente des valeurs E et CTE semblables.

Quelles que soient les valeurs exactes des modules de Young et des coefficients de dilatation thermique des films de protection et des films d'encapsulant extérieurs, et quelles que soient leurs variations en fonction de la température, le fait que leurs valeurs soient symétriques ou quasi-symétriques par rapport à la couche centrale de l'empilement assure que d'éventuelles contraintes seront également symétriques entre la face arrière et la face avant et par conséquent s'annuleront.

Ce mécanisme est d'autant plus efficace que les matériaux les plus rigides ayant des modules d'Young les plus élevés sont positionnés au niveau des deux faces extérieures de l'empilement, ce qui maintient l'ensemble de la structure, même si les valeurs des modules d'Young et des coefficients de dilatation thermique du couple plaque ou film de protection avant/plaque ou film de protection arrière et/ou du couple premier film d'encapsulant extérieur/deuxième film d'encapsulant extérieur ne sont pas parfaitement identiques. Le matériau le moins stable thermomécaniquement et le plus mou (le film d'encapsulant intérieur) se trouve au centre de l'empilement, et donc au centre de symétrie. Il ne pourra donc pas provoquer de déformation de l'empilement.

Une architecture avec de telles caractéristiques thermomécaniques présente un aspect plan pouvant être conservé sur une large plage de température allant, notamment de - 40°C à +85°C. Cette gamme de température englobe la totalité ou la quasi-totalité des conditions auxquelles des routes peuvent être exposées. Les déformations mécaniques dues aux expansions différentielles à haute température et aux contractions différentielles à basse température sont minimisées. Le dispositif n'est pas déformé avec les variations de température.

De plus, le dispositif comporte des couches continues et non pas discontinues, ce qui simplifie le procédé de fabrication.

Avantageusement, les modules d'Young E₁ et E₅ sont supérieurs à 2 GPa, de préférence supérieurs à 5 GPa et encore plus préférentiellement supérieurs à 10 GPa. Les éléments actifs sont protégés mécaniquement, en particulier en cas d'impact mécanique ou de la présence d'une forte charge sur le dispositif, notamment après application sur une chaussée circulable. A titre illustratif et non limitatif, les impacts mécaniques peuvent être un poinçonnement par la face arrière du dispositif (par des aspérités de la chaussée circulable sous-jacente); poinçonnement par la face avant du dispositif dû à la circulation ; choc mécanique sur la face-avant (par exemple par impact de grêlons ou chute d'objets) ; compression du dispositif par la face avant due au trafic, à la présence d'un poids mort, ou d'une masse tombante ; cisaillement. Les éléments actifs ne sont pas dégradés, leurs performances et/ou leurs fonctionnalités demeurent intactes. En particulier, dans le cas où les éléments actifs sont des cellules photovoltaïques, cela évite de les casser. Dans le cas où les éléments actifs sont des diodes électroluminescentes (LED), cela évite de les détériorer et de diminuer leur luminosité.

Avantageusement, les modules d'Young E₂ et E₄ vont de 100 à 800 MPa et de préférence de 150 à 750 MPa, et de préférence de 200 à 600 MPa.

Avantageusement, le module d'Young E₃ va de 5 à 150 MPa, et de préférence de 5 à 100 MPa et encore avantageusement de 10 à 100 MPa, voire de 10 à 50 MPa. Avantageusement, les coefficients de dilatation thermique CTE₁ et CTE₅ sont inférieurs à 200×10⁻⁶/K, de préférence inférieurs à 100×10⁻⁶/K et encore plus préférentiellement inférieurs à 50×10⁻⁶/K.

Avantageusement, les coefficients de dilatation thermique CTE₂ et CTE₄ vont de 200x 10⁻⁶/K à 700×10⁻⁶/K, et de préférence de 300×10⁻⁶/K à 600×10⁻⁶/K.

Avantageusement, le coefficient de dilatation thermique E₃ va de 800×10⁻⁶/K à 2000x 10⁻⁶/K, et de préférence de 800×10⁻⁶/K à 1400×10⁻⁶/K.

Avantageusement, le premier matériau et le cinquième matériau sont des composites fibres de verre/polymère, identiques ou différents.

Avantageusement, le deuxième matériau et le quatrième matériau sont des ionomères, identiques ou différents.

Avantageusement, les éléments actifs sont protégés, par les premier et deuxième films de protection et par les premier et deuxième films encapsulant extérieurs, de l'humidité et/ou des fluides habituellement présents dans le milieu routier, tels que les carburants, les huiles, les solvants et/ou les eaux salées. De plus, les interfaces film encapsulant extérieur/film encapsulant intérieur sont protégées d'une éventuelle dégradation structurelle due à une pénétration de molécules d'eau.

Avantageusement, le troisième matériau est une polyoléfine thermoplastique ou une résine (méth)acrylique. Ce type de matériau renforce la protection des éléments actifs vis-à-vis de l'humidité et/ou des fluides présents dans le milieu routier. Avantageusement, l'épaisseur du premier film de protection et du deuxième film de protection va de 0,25 mm à 3,0 mm, et de préférence, de 0,5 mm à 1,5 mm. Avantageusement, l'épaisseur du premier film encapsulant extérieur et du deuxième film encapsulant extérieur va de 0,2 mm à 2,0 mm, de préférence de 0,25 mm à 2,0 mm, de façon encore préférée de 0,25 mm à 1,0 mm et avantageusement de 0,40 mm à 1 mm. Avantageusement, l'épaisseur du film encapsulant intérieur va de 0,4 mm à 2,5 mm, et de préférence, de 0,4 mm à 2,0 mm et avantageusement de 0,8 mm à 1,4 mm, voire de0,8 mm à 1,6 mm.

Avantageusement, la force d'adhésion entre le premier film de protection et le premier film encapsulant extérieur, entre le premier film encapsulant extérieur et le film encapsulant intérieur, entre le film encapsulant intérieur et le deuxième film encapsulant extérieur, et/ou entre le deuxième film encapsulant extérieur et le deuxième film de protection est la plus élevée possible. Une grande force d'adhésion permet de minimiser les risques de délamination aux interfaces.

Avantageusement, les éléments actifs, aussi appelés éléments fonctionnels, sont des éléments photovoltaïques, électriques, électroniques, optiques, opto-électriques, piézo-électriques, thermoélectriques, et/ou de communication sans fil. Notamment, les éléments actifs, sont des éléments photovoltaïques, électriques, électroniques, optiques, opto-électriques, piézo-électriques et/ou thermoélectriques. En particulier, les éléments actifs peuvent être des cellules photovoltaïques et/ou des diodes électroluminescentes et/ou des diodes électroluminescentes organiques (OLEDs).

Les éléments actifs sont enrobés dans au moins un des films choisis parmi le premier film encapsulant extérieur, le film encapsulant intérieur et le deuxième film encapsulant extérieur. Chaque élément actif peut être totalement enrobé dans un seul film, ou se trouver à l'interface entre deux desdits films.

Le dispositif de l'invention est plan et non-courbé et peut être intégré sur une chaussée circulable plane sur laquelle passent des piétons, voitures, vélos, et/ou camions, à faible vitesse et/ou à vitesse rapide. De plus, le dispositif présente un certain degré de flexibilité (i.e. il peut fléchir sans casser et les composants actifs ne seront pas détériorés) ce qui le rend compatible avec une chaussée circulable présentant une légère courbure, pouvant être de l'ordre de 5 mm sur une distance typique de 1 m.

L'invention concerne également une chaussée circulable fonctionnalisée comprenant une chaussée circulable sur laquelle est fixé un dispositif fonctionnel tel que défini précédemment, par l'intermédiaire d'une couche de fixation, la première plaque (ou premier film de protection) du dispositif fonctionnel étant recouverte par une couche de revêtement, pour permettre le passage de piétons et/ou de véhicules, la couche de revêtement étant non opaque et présentant une surface extérieure texturée.

L'invention concerne également un procédé pour fabriquer une chaussée circulable fonctionnalisée comprenant les étapes suivantes :
a) fourniture d'un dispositif fonctionnel tel que défini précédemment,
b) fixation du dispositif fonctionnel sur une chaussée circulable, par l'intermédiaire d'une couche de fixation,
c) dépôt d'une couche de revêtement, sur le premier film de protection du dispositif fonctionnel, pour permettre le passage de piétons et/ou de véhicules, la couche de revêtement étant non opaque et présentant une surface extérieure texturée.

L'ordre des étapes b) et c) peut être inversé.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 représente, de manière schématique, un dispositif fonctionnel, en coupe et vue de profil, selon un mode de réalisation particulier de l'invention,
La figure 2 représente, de manière schématique, un dispositif fonctionnel, en coupe et vue de profil, selon un autre mode de réalisation particulier de l'invention, et intégré sur une chaussée circulable fonctionnalisée.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Par la suite, même si la description fait référence à un dispositif fonctionnel 100 comprenant des cellules photovoltaïques 110, l'invention est transposable à tout dispositif comprenant des éléments actifs 110 électriques, électroniques, optiques, opto-électriques, piézo-électriques, thermoélectriques, et/ou de communication sans fil.

### Dispositif fonctionnel 100 intégrable dans une zone circulable :

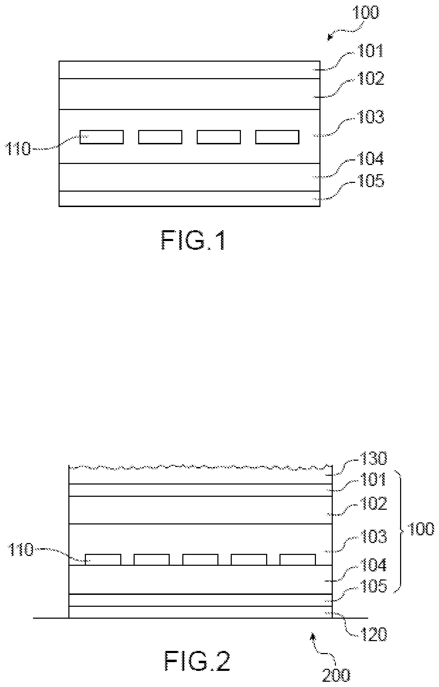

On se réfère aux figures 1 et 2 qui représentent un dispositif fonctionnel 100 intégrable dans une zone circulable 200. Le dispositif 100 comprend successivement :
- une première plaque également appelée premier film de protection 101, disposée en face avant du dispositif 100, ayant une première épaisseur e₁, en un premier matériau, ayant un premier module d'Young E₁ et un premier coefficient de dilatation thermique CTE₁,
- un premier film encapsulant extérieur 102, ayant une deuxième épaisseur e₂, en un deuxième matériau, ayant un deuxième module d'Young E₂ et un deuxième coefficient de dilatation thermique CTE₂,
- un film encapsulant intérieur 103, enrobant des cellules photovoltaïques 110, le film encapsulant intérieur 103 ayant une troisième épaisseur e₃, en un troisième matériau, ayant un troisième module d'Young E₃ et un troisième coefficient de dilatation thermique CTE₃,
- un deuxième film encapsulant extérieur 104, ayant une quatrième épaisseur e₄, en un quatrième matériau, ayant un quatrième module d'Young E₄ et un quatrième coefficient de dilatation thermique CTE₄,
- une deuxième plaque également appelée deuxième film de protection 105, disposée en face arrière du dispositif, ayant une cinquième épaisseur e₅, en un cinquième matériau, ayant un cinquième module d'Young E₅ et un cinquième coefficient de dilatation thermique CTE₅.

### Première plaque 101 et deuxième plaque 105 :

La première plaque 101 et la deuxième plaque 105 sont les éléments du dispositif en contact direct avec l'environnement extérieur.

Les plaques 101, 105 sont en des matériaux ayant un module de Young élevé. De préférence, leurs modules d'Young E sont supérieurs à 2 GPa, avantageusement supérieurs à 5 GPa, encore plus avantageusement supérieurs à 10 GPa. Les modules d'Young demeurent élevés au moins sur toute la gamme de température de fonctionnement du dispositif fonctionnel (de -40°C à +85°C). Cette rigidité élevée peut permettre de réduire, voire d'empêcher, le poinçonnement des cellules photovoltaïques 110 par la face avant ou par la face arrière du module, c'est-à-dire l'apparition de fissures et/ou de cassures des cellules photovoltaïques 110, lorsque celui-ci est appliqué sur un support présentant une rugosité de surface importante.

La première plaque 101 et la deuxième plaque 105 présentent une grande rigidité mécanique, sont peu déformables et résistantes aux impacts.

La première plaque 101 et la deuxième plaque 105 sont réalisées en des matériaux ayant un coefficient de dilatation thermique faible. De préférence, leurs coefficients de dilation thermique CTE sont inférieurs à 200×10⁻⁶/K, avantageusement inférieurs à 100×10⁻⁶/K, et encore plus avantageusement inférieurs à 50×10⁻⁶/K. Elles présentent une grande stabilité dimensionnelle sous variation de température.

La combinaison d'un module d'Young E élevé et d'un coefficient de dilatation thermique CTE faible dans les deux plaques 101 et 105 assure la stabilité thermomécanique du dispositif.

De préférence, les modules d'Young de la première plaque 101 et de la deuxième plaque 105 sont supérieurs à 10 GPa et leurs coefficients de dilatation thermique sont inférieurs à 50×10⁻⁶/K.

De manière avantageuse, pour éviter d'avoir un matériau qui se dilate plus que l'autre sous l'effet de la chaleur et/ou se contracte plus que l'autre sous l'effet du froid, et donc pour éviter d'induire des contraintes mécaniques inhomogènes dans l'assemblage, des matériaux ayant des valeurs de module d'Young (E) et de coefficient d'expansion thermique (CTE) les plus proches possibles les uns des autres seront utilisés pour la première plaque 101 et pour la deuxième plaque 105. Par le plus proche, on entend que ces valeurs différeront de 0 à 30% maximum, de préférence de 0 à 20% et de préférence encore de 0 à 10%, et avantageusement elles sont identiques.

Comme les deux plaques (ou films) de protection 101, 105 sont en contact avec l'environnement extérieur, elles peuvent jouer également le rôle de barrières aux influences externes (notamment à l'humidité). Elles présentent, avantageusement, les caractéristiques supplémentaires suivantes :
- une grande résistance à la pénétration de H₂O,
- une stabilité intrinsèque contre la dégradation structurelle par molécules de H₂O,
- une grande résistance à l'exposition aux fluides chimiques.

Par exemple, les première 101 et deuxième 105 plaques sont en un matériau ayant une vitesse de transmission de la vapeur d'eau (WVTR pour « Water Vapor Transmission Rate ») la plus faible possible.

Avantageusement, la première plaque 101 et la deuxième plaque 105 sont en un matériau comprenant de 50% à 70% massique de verre pour répondre au mieux aux exigences des paramètres thermomécaniques E et CTE.

Par exemple, la première plaque 101 et la deuxième plaque 105 sont en des matériaux composites de fibres de verre et de résine ou en composite de fibres de verre et de polymère. Par exemple, il s'agit d'une résine époxyde ou acrylique, d'un polymère thermoplastique, comme une polyoléfine thermoplastique, comme le polypropylène (PP), d'un ionomère, d'un polyuréthane, d'un polyamide, d'un polyvinyl chloride, d'un (méth)acrylate, d'un polycarbonate, d'un polymère fluoré, ou encore d'un polyester tel que le poly(téréphtalate d'éthylène) (PET ou encore PETG).

Les fibres de verre représentent, avantageusement, de 50% à 70% massique et, de préférence, 55% à 65% massique du matériau. Elles peuvent être tissées (uni- ou bidirectionnelles) ou non tissées.

La protection mécanique des éléments actifs aux basses températures (jusqu'à -40°C) et aux hautes températures (jusqu'à +85°C) est assurée, compte tenu du durcissement ou du ramollissement des matériaux encapsulants, par la stabilité mécanique des matériaux composites.

Les matériaux des première et deuxième plaques peuvent être différents entre eux, à condition de rester semblables en termes de E et CTE.

Avantageusement, les matériaux des première et deuxième plaques sont identiques.

La première plaque 101 et la deuxième plaque 105 ont une épaisseur allant de 0,25 à 3,0 mm, avantageusement allant de 0,5 à 1,5 mm.

La première plaque 101 et la deuxième plaque 105 peuvent avoir des épaisseurs identiques ou différentes mais qui restent semblables. Avantageusement, elles sont de même épaisseur.

La première plaque 101 en face avant, faisant face aux faces actives des cellules photovoltaïques, est transparente, de sorte à laisser passer le rayonnement solaire. Par transparente, on entend qu'elle laisse passer plus de 70% du rayonnement incident, et de préférence au moins 80%, dans le spectre visible.

La deuxième plaque 105 positionnée en face arrière peut être opaque ou transparente.

### Premier film encapsulant extérieur 102 et deuxième film encapsulant extérieur 104 :

Le premier film encapsulant extérieur 102 et le deuxième film encapsulant extérieur 104 sont réalisés en des matériaux ayant des modules d'Young moyens, de préférence de 100 à 800 MPa, encore préférentiellement de 150 à 750 MPa, plus préférentiellement de 200 à 600 MPa.

Les films encapsulants extérieurs 102, 104 présentent une rigidité mécanique moyenne, sont moyennement déformables et résistants aux impacts.

Ils sont réalisés en des matériaux ayant un coefficient de dilatation thermique moyen de 200×10⁻⁶/K à 700×10⁻⁶/K, avantageusement de 300×10⁻⁶/K à 600×10⁻⁶/K. Ils présentent une stabilité dimensionnelle moyenne sous variation de température.

La combinaison d'un module d'Young E moyen et d'un coefficient de dilatation thermique moyen renforce l'action stabilisante de la première symétrie verticale obtenue par les plaques (ou films) de protection, ce qui assure la stabilité thermomécanique du dispositif. Les matériaux des films encapsulant extérieurs 102, 104 peuvent être différents entre eux, à condition de rester semblables en termes de E et CTE. Avantageusement, les films encapsulant extérieurs 102, 104 ont un E de l'ordre de 500 MPa et un CTE de l'ordre de 400×10⁻⁶/K.

Avantageusement, les matériaux des films encapsulant extérieurs sont identiques.

Les films encapsulant extérieurs 102, 104 sont, avantageusement, en des matériaux permettant de renforcer la fonction de barrière des matériaux des plaques (ou films) de protection, vis-à-vis des influences externes (notamment vis-à-vis de l'humidité).

Par exemple, les films encapsulant extérieurs 102, 104 sont en polymères, comme des homopolymères ou des copolymères d'éthylène acétate de vinyl (EVA), éthylène méthylacrylate (EMA), éthylène butylacrylate (EBA), éthylène propylène (EPDM), polyvinyl butyral (PVB), polydiméthylsiloxanes, polyuréthanes (PU), polyoléfines thermoplastiques, ionomers, polypropylène (PP), polyamide, polyvinyl chloride, polycarbonate, polymères fluorés, ou encore d'un polyester tel que le poly(téréphtalate d'éthylène) (PET ou encore PETG). De préférence, il s'agit d'un ionomère.

Le premier film d'encapsulant extérieur 102 et le deuxième film d'encapsulant extérieur 104 ont une épaisseur allant de 0,2 mm à 2,0 mm, de préférence de 0,25 mm à 2,0 mm, avantageusement allant de 0,4 mm à 1,0 mm et encore avantageusement de 0,25 mm à 0,75 mm.

Avantageusement, ils ont la même épaisseur.

### Film encapsulant intérieur 103 :

Le matériau du film d'encapsulant intérieur 103 présente un module d'Young faible, inférieur à celui des films encapsulant extérieurs. Son module d'Young E₃ va de 5 à 150 MPa, de préférence de 5 à 100 MPa, avantageusement de 10 à 100 MPa, encore plus avantageusement de 10 à 50 MPa. Le film encapsulant intérieur a une rigidité mécanique faible, une bonne capacité de déformation pour pouvoir absorber les contraintes et impacts mécaniques. La stabilité mécanique de l'ensemble de la structure est assurée par les autres couches de l'empilement.

Le matériau du film d'encapsulant intérieur 103 présente un coefficient de dilatation thermique élevé, de préférence entre 800 à 2000×10⁻⁶/K, encore plus préférentiellement entre 800 à 1400×10⁻⁶/K.

De préférence, le matériau est caractérisé par E₃ ~20 MPa et CTE₃ ~ 900×10⁻⁶/K.

Le film encapsulant intérieur 103 est, par exemple, un encapsulant couramment utilisé dans le domaine du photovoltaïque.

Il peut s'agir d'un matériau polymère, comme des homopolymères ou des copolymères d'éthylène acétate de vinyl (EVA), éthylène méthylacrylate (EMA), éthylène butylacrylate (EBA), éthylène propylène (EPDM), polyvinyl butyral (PVB), polydiméthylsiloxanes, polyuréthanes (PU), polyoléfines thermoplastiques, ionomers, polypropylène (PP), polyamide, polyvinyl chloride, polycarbonate, polymères fluorés, ou encore d'un polyester tel que le poly(téréphtalate d'éthylène) (PET ou encore PETG). Il peut également s'agir d'une résine de type (méth)acrylique, ou d'un silicone réticulable à chaud ou photochimiquement. De préférence, il s'agit d'une polyoléfine thermoplastique (TPO).

Le film encapsulant intérieur 103 a une épaisseur allant de 0,4 à 2,5 mm, notamment de 0,4 mm à 2,0 mm, avantageusement de 0,8 mm à 1,4 mm, notamment de 0,8 à 1,6 mm.

Avantageusement, le film encapsulant intérieur 103 peut présenter une résistance à la pénétration de H₂O élevée, une grande stabilité intrinsèque contre la dégradation structurelle par molécules de H₂O ainsi qu'une résistance à l'exposition aux fluides chimiques élevée.

Avantageusement, la résistance à la pénétration de l'humidité des différents matériaux est croissante depuis le film encapsulant intérieur 103 vers les plaques (ou films) de protection 101 et 105, en face avant et en face arrière.

### Eléments actifs 110 :

Le dispositif fonctionnel 100 comprend au moins un élément actif 110, et de préférence, plusieurs éléments actifs 110, de même fonctionnalité ou de fonctionnalités différentes. Selon une première variante, les éléments actifs 110 sont disposés entre le film encapsulant intérieur 103 et le deuxième film d'encapsulant extérieur 104, comme représenté sur la figure 2).

Alternativement, les éléments actifs 110 sont disposés entre le film encapsulant intérieur 103 et le premier film d'encapsulant extérieur 102.

De préférence, les éléments actifs 110 sont complètement enrobés et centrés dans le film encapsulant intérieur 103 (comme représenté sur la figure 1).

Les éléments actifs pourraient également selon une autre variante être enrobés dans le film deuxième encapsulant extérieur 104, en contact avec la deuxième plaque de protection 105.

Au centre de l'empilement, les éléments actifs peuvent ne pas être centrés dans le film d'encapsulant intérieur 103. Cela ne perturbe pas la stabilité thermomécanique de l'empilement, car celle-ci est assurée par les couples première plaque de protection 101/deuxième plaque de protection 105 et premier film d'encapsulant extérieur 102/deuxième film d'encapsulant extérieur 104, qui tiennent la structure.

Les éléments actifs 110 sont, par exemple, des cellules photovoltaïques. Elles sont, par exemple, à base de silicium, mono-cristallin, multi-cristallin ou quasi mono-cristallin également connu sous le nom anglo-saxon de 'mono-like'. Elles peuvent être de silicium type P ou de type N. Les cellules sont, par exemple, sous la forme de fines plaques. Leur épaisseur est, avantageusement, entre 100 et 240 µm, par exemple d'environ 180 à 200 µm. La dimension de chaque cellule peut être conforme à l'un des multiples standards internationaux utilisés dans le domaine du photovoltaïque, tels que les standards M0 ou M2 par exemple. Pour ce type de cellules à base de silicium, le rendement de conversion photovoltaïque est, typiquement, entre 16,0% et 25,0%. Les cellules peuvent présenter une architecture de type 'classique' ou 'dérivé de classique', e.g. Alu-BSF (« Aluminum-Back Surface Field »), PERC (« Passivated Emiter Rear Cell »), PERT (« Passivated Emitter, Rear Totally Diffused »), ou encore alternative comme e.g. Si-hétérojonction, IBC (« Interdigitated Back Contact »), ou des cellules multi-jonctions. Les cellules sont disposées à l'intérieur de la surface du module et interconnectées par des conducteurs électriques.

Les cellules peuvent être disposées côte à côte et, avantageusement, régulièrement espacées. L'espacement entre deux cellules photovoltaïques voisines peut être supérieur ou égal à 1 mm, et de préférence supérieur ou égal à 3 mm. Les deux cellules photovoltaïques voisines considérées peuvent être deux cellules voisines d'une même série (encore désignée par le terme « string » en anglais) ou deux cellules voisines appartenant respectivement à deux « strings » de cellules photovoltaïques.

Les cellules photovoltaïques sont généralement interconnectées entre elles, par des connexions métalliques électriquement conductrices, destinées à collecter l'électricité générée par les cellules photovoltaïques. Les connecteurs électriquement conducteurs peuvent être des connexions métalliques attachées aux connecteurs (ou busbars) de la métallisation de la cellule, par exemple il s'agit de rubans ou de fils en cuivre. Le nombre de rubans d'interconnexion va typiquement de 2 à 6. L'ensemble formé par les cellules photovoltaïques et les connecteurs forme un squelette de cellules photovoltaïques interconnectées.

L'empilement décrit précédemment est constitué de cinq couches 101, 102, 103, 104, 105 entourant les éléments actifs 110. Selon une variante, l'empilement pourrait comprendre un nombre pair de couches additionnelles, par exemple 2 ou 4 couches additionnelles. Les couches additionnelles seraient choisies de manière à présenter également, deux à deux, des caractéristiques thermomécaniques symétriques ou quasi-symétriques par rapport à la couche centrale. Avantageusement les couches additionnelles s'intègrent dans les gradients de propriétés thermomécaniques E (gradient en U) et CTE (gradient en U inversé) de part et d'autre du film encapsulant intérieur.

Les principes de symétries et de gradients appliqués aux modules de Young E et aux coefficients de dilatation thermique CTE peuvent être appliqués à d'autres paramètres de matériau, par exemple à l'épaisseur, ce qui aura pour effet bénéfique de renforcer encore plus la stabilité thermomécanique globale.

Les matériaux et/ou les épaisseurs des plaques ou films de protection 101, 105, des films encapsulants extérieurs 102, 104 et du film encapsulant intérieur 103 sont choisis de manière à obtenir un empilement dans lequel les paramètres clé des matériaux varient de façon symétrique, favorable et bénéfique à la stabilité dimensionnelle, thermomécanique et physico-chimique de l'empilement.

L'empilement est plan et non-courbé, tout en présentant un certain degré de flexibilité, ce qui le rend compatible avec une chaussée circulable plane ou présentant une légère courbure.

### Procédé de fabrication du dispositif fonctionnel 100 :

Selon une première variante, le film encapsulant intérieur 103 est obtenu à partir d'une ou plusieurs couches de matériaux polymères comme ceux mentionnés précédemment. Le procédé de fabrication comporte les étapes successives suivantes :
- empilement des différentes couches constitutives de l'empilement, de manière à former un assemblage,
- lamination de l'assemblage.

L'étape de lamination (aussi appelée étape de laminage) permet, non seulement, de faire fondre puis réticuler ou polymériser les matériaux polymères mais, également, de coller entre elles toutes les couches et éléments actifs constituant l'ensemble de la structure. Chaque film encapsulant 102, 103 et 104, ainsi que les plaques ou films de protection 101 et 105, peut être obtenu à partir d'une ou plusieurs couches empilées d'un même matériau, afin d'obtenir l'épaisseur souhaitée pour chaque film ou plaques après l'étape de lamination.

L'étape de lamination est exécutée à l'aide d'un équipement dit laminateur (aussi appelé laminoir) pouvant être, par exemple, une presse à membrane.

Le procédé de lamination est réalisé à chaud sous vide et sous pression mécanique. La température de lamination est entre 120°C et 200 °C, et avantageusement entre 140°C et 180 °C, avec un temps de procédé ajustable.

En fonction de la nature des matériaux choisis, il est possible de réaliser une ou plusieurs étapes de lamination.

Selon une deuxième variante, le film encapsulant intérieur 103 est obtenu à partir d'encapsulants sous forme initiale liquide polymérisable qui, pendant l'opération de mise en module photovoltaïque sont capables de se transformer par polymérisation voire réticulation en un matériau solide caoutchoutique souple, protégeant les cellules et assurant le collage ou la cohésion de l'assemblage.

### Intégration du dispositif fonctionnel 100 dans une zone circulable 200 :

Le dispositif fonctionnel 100 est intégrable à la surface de chaussées circulables - pour tout moyen de transport roulant, motorisé et/ou non motorisé, et/ou piéton.

La chaussée circulable 200 peut être en divers matériaux et de rigidité variable. La zone circulable 200 est, de manière avantageuse, suffisamment rigide pour ne pas se déformer plus, lorsqu'on applique une contrainte correspondant au passage de trafic, que le dispositif fonctionnel 100. Par exemple, elle correspond à une surface en enrobé du type chaussée.

Le dispositif fonctionnel 100 est, avantageusement, fixé à la structure de chaussée sous-jacente, par une couche de fixation 120. Avantageusement, comme la chaussée circulable 200 peut présenter une rugosité de surface, l'utilisation de la couche de fixation 120 peut permettre de lisser la surface de la chaussée venant en contact avec la face arrière du dispositif fonctionnel 100, ce qui limite voire évite le risque de poinçonnement des cellules photovoltaïques 110 par la face arrière.

La couche de fixation 120 peut comporter une colle, par exemple une colle époxy, acrylique ou polyuréthane, entre autres.

La couche de fixation 120 peut comporter un liant bitumineux, éventuellement renforcé par un ajout d'un polymère tel que du Styrène-Butadiène-Styrène (SBS), à chaud ou en émulsion.

Selon un mode de réalisation, la couche de fixation 120 est directement répandue sur la surface de la chaussée circulable, étalée en couche mince, puis le dispositif fonctionnel 100 y est déposé alors que la colle n'a pas durci ou que le liant bitumineux est encore visqueux et collant. Alternativement, la couche de fixation 120 peut être déposée sur l'empilement 100, et plus particulièrement sur la deuxième plaque 105 de l'empilement 100.

Une couche dite de roulement 130, aussi appelée couche de revêtement ou couche interfacique au trafic, peut être appliquée à la surface de la face avant du dispositif 100 pour permettre notamment le passage de piétons et/ou de véhicules sur une surface non-glissante. Une ou plusieurs couches de revêtement 130 au trafic peuvent être appliquées.

La couche de revêtement 130 satisfait aux critères d'adhérence habituels des surfaces routières et piétonnes. Optionnellement, cette couche de roulement peut aussi contribuer à la protection du dispositif 100 voire des éléments actifs 110 à l'intérieur du dispositif 100.

La couche de revêtement 130 est appliquée sur la face avant du dispositif 100, la couche de revêtement étant non opaque, c.a.d. transparente ou translucide, et présentant une surface extérieure texturée de manière à être anti-dérapante, de préférence une surface extérieure macrotexturée et microtexturée, régulièrement ou de préférence irrégulièrement, avec une profondeur moyenne de texture PMT mesurée selon la norme NF EN 13036-1 comprise idéalement entre 0,2 mm et 3 mm et une valeur de PSV (pour « Polished Stone Value » en anglais) selon la norme NF EN 13043 d'au moins PSV₄₄, mieux PSV₅₀, encore mieux PSV₅₃. Par « irrégulièrement », on entend que les reliefs de la couche de revêtement 130 n'ont pas tous la même forme, ni la même taille. Avantageusement, la profondeur moyenne de texture PMT de la couche de revêtement 130 peut être d'au moins 0,30 mm, mieux d'au moins 0,6 mm.

Selon une variante, la texturation peut être intégrée dans la face avant du dispositif 100 pendant le procédé de fabrication de celui-ci, en particulier dans la première plaque ou le premier film de protection 101.

La couche de revêtement 130 peut avantageusement présenter une surface extérieure reproduisant la texture d'un enduit superficiel routier et circulable.

La couche de revêtement 130 présente avantageusement un taux de transparence supérieur à 50 %, de préférence, supérieur à 80%, et encore de préférence, supérieur à 90%, dans le spectre des longueurs d'ondes visibles.

La couche de revêtement 130 peut par exemple être un liant de type bitumineux tel que défini dans la norme NF EN 12591.

La couche de revêtement 130 peut encore être un liant de synthèse ou d'origine végétale, le liant étant de préférence de nature organique, préférentiellement de nature polymérique, tel qu'une résine acrylique, époxy ou polyuréthane.

Les reliefs de texturation, régulière ou irrégulière, peuvent être obtenus au moins partiellement à partir d'éléments texturants non-opaques, c.a.d. transparents ou translucides, ayant des formes, des tailles et des caractéristiques mécaniques et optiques convenables, disposés à l'intérieur ou à la surface de la couche de revêtement. Ces éléments texturants peuvent être des billes ou des granulats, ou encore des mélanges de ceux-ci, calibrés ou non-calibrés, de matériaux organiques ou minéraux, par exemple de polycarbonate, de verre ou d'oxyde d'aluminium. Ils peuvent avoir une taille allant de 0,1 mm à 10 mm, mieux de 0,4 à 4 mm, encore mieux de 0,9 à 1,4 mm.

### Exemples illustratifs et non limitatifs d'un mode de réalisation :

Dans cet exemple, le dispositif est obtenu en empilant et en laminant les différentes couches constitutives de l'empilement. L'empilement comprend depuis la face avant vers la face arrière :
- une première plaque 101 en un matériau composite comprenant un tissu bi-directionnel de fibres de verre pré-imprégnée d'une résine de type époxy ayant un taux de fibres de verre allant de 50% à 70% massique, et une épaisseur de 0,25 à 3,0 mm, avantageusement de 0,5 à 1,5 mm,
- un premier film d'encapsulant extérieur en un ionomère, ayant une épaisseur allant de 0,2 à 2,0 mm, de préférence 0,25 mm à 1,0 mm, notamment de 0,25 mm à 0,75 mm, avantageusement de 0,4 à 1,0 mm,
- un film encapsulant intérieur en une polyoléfine thermoplastique ayant une épaisseur allant de 0,4 à 2,5 mm, de préférence de 0,4 mm à 2,0 mm, avantageusement de 0,8 à 1,6 mm, par exemple de 0,8 mm à 1,4 mm,
- des cellules photovoltaïques à base de plaquettes de Silicium cristallin,
- un deuxième film d'encapsulant extérieur en un ionomère d'épaisseur de 0,2 à 2,0 mm, de préférence de 0,25 mm à 1,0 mm, avantageusement de 0,4 à 1,0 mm, voire de 0,25 mm à 0,75 mm, de même épaisseur que le premier film d'encapsulant extérieur,
- une deuxième plaque en un matériau composite de fibres de verre bidirectionnelles/polymère PETG, ayant un taux de fibres de verre de 50% à 70% massique, une épaisseur allant de 0,25 à 3,0 mm, avantageusement de 0,5 à 1,5 mm.

Les différentes couches sont empilées sur une plaque de verre, puis laminées à chaud sous vide et sous pression mécanique.

L'empilement peut être fixé à la zone circulable, par une colle époxy, polyuréthane, bitumineuse ou autre, avec un dosage de l'ordre de 1 kg/m² ou supérieur.

## Revendications

1. Dispositif fonctionnel (100), notamment intégrable dans une chaussée circulable (200), comprenant successivement :
- un premier film de protection (101), disposé en face avant du dispositif, en un premier matériau,
- un film encapsulant intérieur (103), en un troisième matériau,
- un deuxième film de protection (105) disposé en face arrière du dispositif, en un cinquième matériau,
**caractérisé en ce que** ledit dispositif fonctionnel (100) comprend également :
- un premier film encapsulant extérieur (102) entre le premier film de protection (101) et le film encapsulant intérieur (103), le premier film encapsulant extérieur (102) étant en un deuxième matériau, et
- un deuxième film encapsulant extérieur (104) entre le film encapsulant intérieur (103) et le deuxième film de protection (105), le deuxième film encapsulant extérieur (104) étant en un quatrième matériau,
- l'un des films choisis parmi le premier film encapsulant extérieur (102), le film encapsulant intérieur (103) et le deuxième film encapsulant extérieur (104), enrobant des éléments actifs (110),
le premier matériau, le deuxième matériau, le troisième matériau, le quatrième matériau et le cinquième matériau ayant, respectivement, des modules d'Young E₁, E₂, E₃, E₄ et E₅ et ayant, respectivement, des coefficients de dilatation thermique CTE₁, CTE₂, CTE₃, CTE₄, et CTE₅,
E₁ et E₅ étant semblables ou identiques, E₂ et E₄ étant semblables ou identiques,
E₁ > E₂ et E₄ < E₅,
CTE₁ et CTE₅ étant semblables ou identiques, CTE₂ et CTE₄ étant semblables ou identiques,
CTE₁ < CTE₂ et CTE₄> CTE₅.

2. Dispositif (100) selon la revendication 1, **caractérisé en ce que** E₂ > E₃ et E₃ < E₄ et **en ce que** CTE₂< CTE₃ et CTE₃ > CTE₄.

3. Dispositif (100) selon l'une des revendications 1 et 2, **caractérisé en ce que** le film encapsulant les éléments actifs (110) est le film encapsulant intérieur (103).

4. Dispositif (100) selon l'une quelconque des revendications précédentes, **caractérisé en ce que** les modules d'Young E₁ et E₅ sont supérieurs à 2 GPa, de préférence supérieurs à 5 GPa et encore plus préférentiellement supérieurs à 10 GPa.

5. Dispositif (100) selon l'une quelconque des revendications précédentes, **caractérisé en ce que** les modules d'Young E₂ et E₄ vont de 150 à 750 MPa, et de préférence de 200 à 600 MPa.

6. Dispositif (100) selon l'une quelconque des revendications précédentes, **caractérisé en ce que** le module d'Young E₃ va de 5 à 150 MPa, et de préférence de 10 à 100 MPa.

7. Dispositif (100) selon l'une quelconque des revendications précédentes, **caractérisé en ce que** les coefficients de dilatation thermique CTE₁ et CTE₅ sont inférieurs à 200×10⁻⁶/K, de préférence inférieurs à 100×10⁻⁶/K et encore plus préférentiellement inférieurs à 50×10⁻⁶/K.

8. Dispositif (100) selon l'une quelconque des revendications précédentes, **caractérisé en ce que** les coefficients de dilatation thermique CTE₂ et CTE₄ vont de 200×10⁻⁶/K à 700x 10⁻⁶/K, et de préférence de 300×10⁻⁶/K à 600×10⁻⁶/K.

9. Dispositif (100) selon l'une quelconque des revendications précédentes, **caractérisé en ce que** le coefficient de dilatation thermique CTE₃ va de 800×10⁻⁶/K à 2000×10⁻⁶/K, et de préférence de 800×10⁻⁶/K à 1400×10⁻⁶/K.

10. Dispositif (100) selon l'une quelconque des revendications précédentes, **caractérisé en ce que** le premier matériau et le cinquième matériau sont des composites fibres de verre/polymère, identiques ou différents.

11. Dispositif (100) selon l'une quelconque des revendications précédentes, **caractérisé en ce que** le deuxième matériau et le quatrième matériau sont des ionomères, identiques ou différents.

12. Dispositif (100) selon l'une quelconque des revendications précédentes, **caractérisé en ce que** le troisième matériau est une polyoléfine thermoplastique ou une résine (méth)acrylique.

13. Dispositif (100) selon l'une quelconque des revendications précédentes, **caractérisé en ce que** l'épaisseur du premier film de protection (101) et du deuxième film de protection (105) va de 0,25 mm à 3,0 mm, et de préférence, de 0,5 mm à 1,5 mm.

14. Dispositif (100) selon l'une quelconque des revendications précédentes, **caractérisé en ce que** l'épaisseur du premier film encapsulant extérieur (102) et du deuxième film encapsulant extérieur (104) va de 0,2 mm à 2,0 mm, et de préférence, de 0,4 mm à 1,0 mm.

15. Dispositif (100) selon l'une quelconque des revendications précédentes, **caractérisé en ce que** l'épaisseur du film encapsulant intérieur (103) va de 0,4 mm à 2,5 mm, et de préférence, de 0,8 mm à 1,6 mm.

16. Dispositif (100) selon l'une quelconque des revendications précédentes, **caractérisé en ce que** les éléments actifs (110) sont des éléments photovoltaïques, électriques, électroniques, optiques, opto-électriques, piézo-électriques, thermoélectriques, de communication sans fil, ou des diodes électroluminescentes (LEDs) ou des diodes électroluminescentes organiques (OLEDs).

17. Dispositif (100) selon l'une quelconque des revendications précédentes, **caractérisé en ce que** des éléments texturants sont intégrés dans le premier film de protection (101).

18. Chaussée circulable fonctionnalisée, comprenant une chaussée circulable (200) sur laquelle est fixée un dispositif fonctionnel (100) tel que défini dans l'une quelconque des revendications 1 à 17, par l'intermédiaire d'une couche de fixation (120), le premier film de protection (101) du dispositif fonctionnel (100) étant recouvert par une couche de revêtement (130), pour permettre le passage de piétons et/ou de véhicules, la couche de revêtement (130) étant non opaque et présentant une surface extérieure texturée.

19. Procédé pour fabriquer une chaussée circulable fonctionnalisée comprenant les étapes suivantes :
a) fourniture d'un dispositif fonctionnel (100),
b) fixation du dispositif fonctionnel (100) sur une chaussée circulable (200), par l'intermédiaire d'une couche de fixation (120),
c) dépôt d'une couche de revêtement (130), sur le premier film de protection (101) du dispositif fonctionnel (100), pour permettre le passage de piétons et/ou de véhicules, la couche de revêtement (130) étant non opaque et présentant une surface extérieure texturée,
**caractérisé en ce que** ledit dispositif fonctionnel (100) est tel que défini dans l'une quelconque des revendications 1 à 17.

## Patentansprüche

1. Insbesondere in eine befahr- oder begehbare Chaussee (200) integrierbare funktionale Vorrichtung (100), die aufeinanderfolgend
- einen ersten Schutzfilm (101) aus einem ersten Material, der auf der Vorderseite der Vorrichtung angeordnet ist,
- einen inneren umhüllenden Film (103) aus einem dritten Material,
- einen auf der Rückseite der Vorrichtung angeordneten zweiten Schutzfilm (105) aus einem fünften Material,
aufweist,
**dadurch gekennzeichnet, daß** die funktionelle Vorrichtung (100) außerdem
- einen ersten äußeren umhüllenden Film (102) zwischen dem ersten Schutzfilm (101) und dem inneren umhüllenden Film (103), wobei der erste äußere umhüllende Film (102) aus einem zweiten Material besteht, und
- einen zweiten äußeren umhüllenden Film (104) zwischen dem inneren umhüllenden Film (103) und dem zweiten Schutzfilm (105), wobei der zweite äußere umhüllende Film (104) aus einem fünften Material besteht,
aufweist,
- wobei ein aus dem ersten äußeren umhüllenden Film (102), dem inneren umhüllenden Film (103) und dem zweiten äußeren umhüllenden Film (104) ausgewählter Film die aktiven Elemente (110) umhüllt,
wobei das erste Material, das zweite Material, das dritte Material, das vierte Material und das fünfte Material die Elastizitätsmodule E₁, E₂, E₃, E₄ beziehungsweise E₅ und die thermischen Ausdehnungskoeffizienten CTE₁, CTE₂, CTE₃, CTE₄ beziehungsweise CTE₅ haben,
wobei E₁ und E₅ ähnlich oder gleich sind, E₂ und E₄ ähnlich oder gleich sind,
E₁ > E₂ und E₄ < E₅ sind,
CTE₁ und CTE₅ ähnlich oder gleich sind, CTE₂ und CTE₄ ähnlich oder gleich sind, CTE₁ < CTE₂ und CTE₄ > CTE₅ sind.

2. Vorrichtung (100) gemäß Anspruch 1, **dadurch gekennzeichnet, daß** E₂ > E₃ und E₃ < E₄ sind und daß CTE₂ < CTE₃ und CTE₃ > CTE₄ sind.

3. Vorrichtung (100) gemäß einem der Ansprüche 1 und 2, **dadurch gekennzeichnet, daß** der die aktiven Elemente umhüllende Film (110) der innere umhüllende Film (103) ist.

4. Vorrichtung (100) gemäß einem der vorangehenden Ansprüche, **dadurch gekennzeichnet, daß** die Elastizitätsmodule E₁ und E₅ größer als 2 GPa, vorzugsweise größer als 5 GPa und in besonders bevorzugter Weise größer als 10 GPa sind.

5. Vorrichtung (100) gemäß einem der vorangehenden Ansprüche, **dadurch gekennzeichnet, daß** die Elastizitätsmodule E₂ und E₄ von 150 bis 750 MPa und vorzugsweise von 200 bis 600 MPa betragen.

6. Vorrichtung (100) gemäß einem der vorangehenden Ansprüche, **dadurch gekennzeichnet, daß** das Elastizitätsmodul E₃ von 5 bis 150 MPa und vorzugsweise von 10 bis 100 MPa beträgt.

7. Vorrichtung (100) gemäß einem der vorangehenden Ansprüche, **dadurch gekennzeichnet, daß** die thermischen Ausdehnungskoeffizienten CTE₁ und ×CTE₅ kleiner als 200 × 10⁻⁶ /K, vorzugsweise kleiner als 100 × 10⁻⁶ /K und in besonders bevorzugter Weise kleiner als 50 × 10⁻⁶ /K sind.

8. Vorrichtung (100) gemäß einem der vorangehenden Ansprüche, **dadurch gekennzeichnet, daß** die thermischen Ausdehnungskoeffizienten CTE₂ und CTE₄ von 200 × 10⁻⁶ /K bis 700 × 10⁻⁶ /K und vorzugsweise von 300 × 10⁻⁶ /K bis 600 × 10⁻⁶ /K betragen.

9. Vorrichtung (100) gemäß einem der vorangehenden Ansprüche, **dadurch gekennzeichnet, daß** der thermische Ausdehnungskoeffizient CTE₃ von 800 × 10⁻⁶ /K bis 2000 × 10⁻⁶ /K und vorzugsweise von 800 × 10⁻⁶ /K bis 1400 × 10⁻⁶ /K beträgt.

10. Vorrichtung (100) gemäß einem der vorangehenden Ansprüche, **dadurch gekennzeichnet, daß** das erste Material und das fünfte Material identische oder unterschiedliche Verbundwerkstoffe aus Glasfasern/Polymer sind.

11. Vorrichtung (100) gemäß einem der vorangehenden Ansprüche, **dadurch gekennzeichnet, daß** das zweite Material und das vierte Material identische oder unterschiedliche Ionomere sind.

12. Vorrichtung (100) gemäß einem der vorangehenden Ansprüche, **dadurch gekennzeichnet, daß** das dritte Material ein thermoplastisches Polyolefin oder ein (Meth)Akrylharz ist.

13. Vorrichtung (100) gemäß einem der vorangehenden Ansprüche, **dadurch gekennzeichnet, daß** die Dicke des ersten Schutzfilms (101) und des zweiten Schutzfilms (105) von 0,25 mm bis 3,0 mm und vorzugsweise von 0,5 mm bis 1,5 mm beträgt.

14. Vorrichtung (100) gemäß einem der vorangehenden Ansprüche, **dadurch gekennzeichnet, daß** die Dicke des ersten äußeren umhüllenden Films (102) und des zweiten äußeren umhüllenden Films (104) von 0,2 mm bis 2,0 mm und vorzugsweise von 0,4 mm bis 1,0 mm beträgt.

15. Vorrichtung (100) gemäß einem der vorangehenden Ansprüche, **dadurch gekennzeichnet, daß** die Dicke des inneren umhüllenden Films (103) von 0,4 mm bis 2,5 mm und vorzugsweise von 0,8 mm bis 1,6 mm beträgt.

16. Vorrichtung (100) gemäß einem der vorangehenden Ansprüche, **dadurch gekennzeichnet, daß** die aktiven Elemente (110) fotovoltaische, elektrische, elektronische, optische, optoelektrische, piezoelektrische, thermoelektrische Elemente oder Elemente für drahtlose Kommunikation oder Leuchtdioden (LED) oder organische Leuchtdioden (OLED) sind.

17. Vorrichtung (100) gemäß einem der vorangehenden Ansprüche, **dadurch gekennzeichnet, daß** die texturierenden Elemente in den ersten Schutzfilm integriert sind.

18. Funktionalisierte befahr- oder begehbare Chaussee, die eine befahr- oder begehbare Chaussee (200) aufweist, auf der eine wie in einem der Ansprüche 1 bis 17 definierte funktionelle Vorrichtung (100) mittels einer Befestigungsschicht (120) befestigt ist, wobei der erste Schutzfilm (101) der funktionellen Vorrichtung (100) mit einer Überzugsschicht (130) überzogen ist, um das Begehen/Befahren durch Fußgänger und/oder Fahrzeuge zu ermöglichen, wobei die Überzugsschicht (130) nicht opak ist und eine texturierte äußere Oberfläche aufweist.

19. Verfahren zum Herstellen einer funktionalisierten befahr- oder begehbaren Chaussee (200) mit den folgenden Schritten:
a) Bereitstellen einer funktionellen Vorrichtung (100),
b) Befestigen der funktionellen Vorrichtung (100) auf einer befahr- oder begehbaren Chaussee (200) mittels einer Befestigungsschicht (120),
c) Auftragen einer Überzugsschicht (130) auf den ersten Schutzfilm (101) der funktionellen Vorrichtung (100), um das Begehen/Befahren durch Fußgänger und/oder Fahrzeuge zu ermöglichen, wobei die Überzugsschicht (130) nicht opak ist und eine texturierte äußere Oberfläche aufweist,
**dadurch gekennzeichnet, daß** die funktionelle Vorrichtung (100) wie in einem der Ansprüche 1 bis 17 definiert ist.

## Claims

1. Functional device (100), in particular integrable into a trafficable pavement (200), comprising successively:
- a first protective film (101), arranged on the front face of the device, made of a first material,
- an internal encapsulation film (103), made of a third material,
- a second protective film (105) arranged on the rear face of the device, made of a fifth material,
**characterised in that** said functional device (100) further comprises:
- a first external encapsulation film (102) between the first protective film (101) and the internal encapsulation film (103), the first external encapsulation film (102) being made of a second material,
- a second external encapsulation film (104) between the internal encapsulation film (103) and the second protective film (105), the second external encapsulation film (104) being made of a fourth material,
- one of the films, among the first external encapsulation film (102), the internal encapsulation film (103) and the second external encapsulation film (104), coating active elements (110),
the first material, the second material, the third material, the fourth material and the fifth material having Young's moduli E₁, E₂, E₃, E₄ and E₅, respectively, and coefficients of thermal expansion CTE₁, CTE₂, CTE₃, CTE₄ and CTE₅, respectively,
E₁ and E₅ being similar or identical, E₂ and E₄ being similar or identical,
E₁ > E₂ and E₄ < E₅,
CTE₁ and CTE₅ being similar or identical, CTE₂ and CTE₄ being similar or identical,
CTE₁ < CTE₂ and CTE₄>CTE₅.

2. The device (100) according to claim 1, **characterised in that** E₂ > E₃ and E₃ < E₄ and **in that** CTE₂ < CTE₃ and CTE₃ > CTE₄.

3. The device (100) according to one of claims 1 and 2, **characterised in that** the film encapsulating the active elements (110) is the internal encapsulation film (103).

4. The device (100) according to any one of the preceding claims, **characterised in that** the Young's moduli E₁ and E₅ are higher than 2 GPa, preferably higher than 5 GPa and still more preferably higher than 10 GPa.

5. The device (100) according to any one of the preceding claims, **characterised in that** the Young's moduli E₂ and E₄ are from 150 to 750 MPa, and preferably from 200 to 600 MPa.

6. The device (100) according to any one of the preceding claims, **characterised in that** the Young's modulus E₃ is from 5 to 150 MPa, and preferably from 10 to 100 MPa.

7. The device (100) according to any one of the preceding claims, **characterised in that** the coefficients of thermal expansion CTE₁ and CTE₅ are lower than 200 × 10⁻⁶/K, preferably lower than 100 × 10⁻⁶/K and still preferably lower than 50 × 10⁻⁶/K.

8. The device (100) according to any one of the preceding claims, **characterised in that** the coefficients of thermal expansion CTE₂ and CTE₄ are from 200 × 10⁻⁶/K to 700 × 10⁻⁶/K, preferably from 300 × 10⁻⁶/K to 600 × 10⁻⁶/K.

9. The device (100) according to any one of the preceding claims, **characterised in that** the coefficient of thermal expansion CTE₃ is from 800 × 10⁻⁶/K to 2000 × 10⁻⁶/K, and preferably from 800 × 10⁻⁶/K to 1400 × 10⁻⁶/K.

10. The device (100) according to any one of the preceding claims, **characterised in that** the first material and the fifth material are identical or different fiberglass / polymer composites.

11. The device (100) according to anyone of the preceding claims, **characterised in that** the second material and the fourth material are identical or different ionomers.

12. The device (100) according to any one of the preceding claims, **characterised in that** the third material is a thermoplastic polyolefin or a (meth)acrylic resin.

13. The device (100) according to any one of the preceding claims, **characterised in that** the thickness of the first protective film (101) and the second protective film (105) is from 0.25 mm to 3,0 mm, and preferably, from 0.5 mm to 1.5 mm.

14. The device (100) according to any one of the preceding claims, **characterised in that** the thickness of the first external encapsulating film (102) and the second external encapsulating film (104) is from 0.2 mm to 2.0 mm, and preferably from 0.4 mm to 1.0 mm.

15. The device (100) according to any one of the preceding claims, **characterised in that** the thickness of the internal encapsulating film (103) is from 0.4 mm to 2.5 mm, and preferably from 0.8 mm to 1.6 mm.

16. The device (100) according to any one of the preceding claims, **characterised in that** the active elements (110) are photovoltaic, electric, electronic, optical, opto-electric, piezoelectric, thermoelectric, wireless communication elements, or light-emitting diodes (LEDs) or organic light-emitting diodes (OLEDs).

17. The device (100) according to any one of the preceding claims, **characterised in that** texturing elements are integrated into the first protective film (101).

18. A functionalized trafficable pavement, comprising a trafficable pavement (200) on which is fastened a functional device (100) as defined in any one of claims 1 to 17, using a fastening layer (120), the first protective film (101) of the functional device (100) being covered with a coating layer (130), to allow the passage of pedestrians and/or vehicles, the coating layer (130) being not opaque and having a textured external surface.

19. A method for manufacturing a functionalized trafficable pavement comprising the following steps:
a) providing a functional device (100),
b) fastening the functional device (100) on a trafficable pavement (200), through a fastening layer (120),
c) depositing a coating layer (130), on the first protective film (101) of the functional device (100), to allow the passage of pedestrians and/or vehicles, the coating layer (130) being not opaque and having a textured external surface,
**characterised in that** said functional device (100) is as defined in any one of claims 1 to 17.
